(19) Europäisches Patentamt

European Patent Office

Office européen des brevets

(11) Numéro de publication: **0 608 938 A1**

## (12) DEMANDE DE BREVET EUROPEEN

(21) Numéro de dépôt: **94200123.1**

(22) Date de dépôt: **19.01.94**

(51) Int. Cl.⁵: **H03F 1/08**, H03F 3/45

(30) Priorité: **27.01.93 FR 9300806**

(43) Date de publication de la demande:
**03.08.94 Bulletin 94/31**

(84) Etats contractants désignés:
**DE FR GB NL**

(71) Demandeur: **PHILIPS COMPOSANTS**
**4, rue du Port aux Vins**
**F-92150 Suresnes(FR)**

㊶ **FR**

(71) Demandeur: **PHILIPS ELECTRONICS N.V.**
**Groenewoudseweg 1**
**NL-5621 BA Eindhoven(NL)**

㊶ **DE GB NL**

(72) Inventeur: **Perraud, Jean-Claude, Société**
**Civile S.P.I.D.**
**156, Boulevard Haussmann**
**F-75008 Paris(FR)**

(74) Mandataire: **Pinchon, Pierre et al**
**Société Civile S.P.I.D.**
**156, Boulevard Haussmann**
**F-75008 Paris (FR)**

(54) **Amplificateur à étage différentiel d'entrée et capacité de stabilisation intégrée.**

㊲ Amplificateur comprenant un étage différentiel d'entrée (T1), (T2) et un miroir de courant (11) dont une branche de commande est insérée dans le trajet de courant de sortie de l'un des transistors (T1) de l'étage d'entrée.

Dans le trajet du courant de sortie de l'autre transistor (T2) de l'étage d'entrée, est insérée une branche de commande d'un deuxième miroir de courant (21), dont le courant de sortie est recopié par un troisième miroir de courant (31), de polarité opposée, les sorties des premier (11) et troisième (31) miroirs de courant sont reliées pour former un noeud (35) de sortie de l'étage d'entrée, lequel est couplé à la branche de commande du premier miroir de courant (11) par l'intermédiaire d'une capacité (Cc) dite de stabilisation en fréquence. De préférence, le premier miroir de courant (11), au moins, a un facteur de multiplication entre entrée et sortie, N qui est plus grand que 1. Ainsi l'effet de la capacité de stabilisation (Cc) est multiplié par (N + 1) de sorte que cette capacité peut être intégrée plus facilement.

Application à des amplificateurs dits opérationnels.

FIG. 1

La présente invention concerne un amplificateur comprenant :

- un étage différentiel d'entrée comportant au moins une paire de transistors d'entrée, dont les électrodes de référence sont couplées entre elles, dont les électrodes de commande sont couplées à un signal d'entrée,
- une capacité dite de stabilisation, disposée de manière à produire une atténuation du signal de sortie pour une fréquence élevée du signal d'entrée,
- et un miroir de courant dont une branche de commande est insérée dans le trajet de courant de sortie de l'un au moins des transistors de ladite paire d'entrée,

Un tel amplificateur peut être réalisé avec des transistors bipolaires, avec des transistors à effet de champ ou encore avec une combinaison des uns et des autres. A cet effet, on a désigné par électrode de référence, l'émetteur d'un transistor bipolaire, ou la source d'un transistor à effet de champ, par électrode de commande, la base ou la grille de l'un ou l'autre de ces transistors.

Le trajet de courant de sortie des transistors, désigne selon les cas, la liaison de collecteur ou de drain vers l'une des bornes d'alimentation du circuit.

Le type d'amplificateur précité est bien connu et est très largement utilisé. Il est à la base de dispositifs tels que des amplificateurs opérationnels, des comparateurs... qui sont soit commercialisés en tant que tels, soit encore, intégrés dans des dispositifs analogiques à fonctionalité plus complexe.

Un exemple d'amplificateur connu est fourni par le circuit portant la référence LM124, commercialisé par la société Philips Semiconductors, dont le schéma est fourni dans la brochure éditée par la même société : "Data Handbook - tome IC11 - General Purpose Linear ICs, 1992" page 8.

Pour des raisons pratiques, il est toujours souhaitable d'intégrer la capacité de stabilisation dans le même corps semiconducteur qui contient l'amplificateur. Cette capacité y occupe une surface en général non négligeable par rapport aux autres éléments de sorte qu'on s'efforce de réduire autant que possible la valeur de la capacité nécessaire à la stabilisation de l'amplificateur. Toutefois, on ne peut réduire cette valeur au point de risquer une instabilité de l'amplificateur à fréquence élevée.

Lorsque l'amplificateur comporte un étage d'amplification intermédiaire à gain très élevé, il est d'usage de disposer la capacité de stabilisation en rétrocouplage de la sortie sur l'entrée de cet étage intermédiaire. On obtient alors une multiplication de capacité par rapport à la valeur physiquement réalisée, par effet Miller, qui met en jeu le gain de cet étage intermédiaire.

Il s'ensuit que la surface de la capacité réellement construite est, dans ce cas, notablement réduite par rapport à la valeur qui aurait été nécessaire en l'absence de la multiplication résultant de l'effet Miller.

Toutefois, le gain de l'étage intermédiaire est le plus souvent imprécis dû aux tolérances de fabrication de sorte que, si la capacité de stabilisation peut être réalisée avec des spécifications étroites, son effet, par contre, sur la stabilité de l'amplificateur à fréquence élevée compte-tenu de la multiplication due à l'effet Miller reste difficile à maîtriser convenablement et est très sensible au type de charge utilisée à la sortie de l'amplificateur.

Dans d'autres types d'amplificateurs, à gain moins élevé, il n'est pas prévu d'étage intermédiaire d'amplificateur. Une solution alors, consisterait à découpler vers la masse, la sortie de l'étage différentiel d'entrée, au moyen de la capacité de stabilisation. Dans ce dernier cas, il n'y a pas d'effet de multiplication de capacité par effet Miller et la capacité de stabilisation devient très encombrante à la surface du semiconducteur.

L'invention, qui vise plus particulièrement des amplificateurs à gains modérés, à pour but de pallier les inconvénients précités.

A cet effet, l'amplificateur selon la présente invention est caractérisé en ce que le dit miroir de courant étant appelé premier miroir, un deuxième miroir de courant est inséré par sa branche de commande dans le trajet de courant de sortie de l'autre transistor de la paire d'entrée, en ce que le courant de sortie de ce deuxième miroir est appliqué à une branche de commande d'un troisième miroir de courant, de polarité inverse de celle des dits premier et deuxième miroirs de courant, en ce que les branches de sortie des premier et troisième miroirs de courant sont reliées pour former un noeud de sortie de l'étage différentiel d'entrée, et en ce que ce noeud est couplé à la branche de commande du premier miroir de courant via la capacité de stabilisation.

Ainsi, le rétrocouplage par la capacité de stabilisation est réalisé au sein même de l'étage différentiel d'entrée.

L'amplificateur selon l'invention présente l'avantage que ses caractéristiques de fonctionnement aux fréquences élevées peuvent être prévues avec une plus grande précision, et il est aisé de garantir à l'avance sa stabilité.

Par ailleurs le rétrocouplage réalisé selon l'invention peut être rendu peu sensible à la nature de la charge en sortie de l'amplificateur.

Lorsque tous les miroirs de courant utilisés ont un rapport de courant nominal de 1 entre leur courant de sortie et leur courant de commande, la capacité de stabilisation voit son effet multiplié par 2. Elle est donc deux fois moins encombrante.

Toutefois, selon un mode préféré de mise en oeuvre de l'invention, l'amplificateur est en outre caractérisé en ce que le troisième miroir de courant étant prévu avec un rapport du courant de sortie au courant de commande pratiquement égal à 1, le rapport du courant de sortie au courant de commande des premier et deuxième miroirs de courant, est choisi égal à N, plus grand que 1.

La capacité de stabilisation voit alors sont effet multiplié par le facteur N + 1 et peut être réalisée avec une surface réduite de semiconducteur.

Cette surface est d'autant plus réduite que le nombre N est élevé, mais les premier et deuxième miroirs de courant ont eux-mêmes un encombrement qui croit avec N. Il existe donc un compromis permettant un encombrement minimal lors de l'intégration dans le corps semiconducteur .

Si par exemple, les premier et deuxième miroirs de courant sont réalisés avec des transistors bipolaires npn, le troisième miroir de courant est alors réalisé avec des transistors pnp avec lesquels il est particulièrement commode de fournir un rapport de courant très proche de 1.

Toutefois, ce mode de mise en oeuvre n'est pas le seul à bénéficier du coefficient (N + 1) de multiplication de la capacité de stabilisation.

Selon un mode de réalisation qui lui est similaire, l'amplificateur est alors caractérisé en ce que le deuxième miroir de courant étant prévu avec un rapport du courant de sortie au courant de commande pratiquement égal à 1, le rapport du courant de sortie au courant de commande des premier et troisième miroirs de courant, est choisi égal à N, plus grand que 1.

Ce dernier mode de réalisation peut se révéler avantageux dans certaines applications, par exemple lorsqu'on utilise des transistors à effet de champ.

La description qui va suivre en regard des dessins annexés, sur des exemples donnés à titre non limitatif, fera bien comprendre comment l'invention peut être réalisée.

La figue 1 représente le schéma électrique d'un premier exemple d'amplificateur conforme à l'invention,

la figure 2 donne le schéma d'un deuxième exemple d'amplification selon l'invention,

la figure 3, une représentation très schématique d'un amplificateur selon l'invention, illustrant une variante relative à l'étage différentiel d'entrée, et

la figure 4, représente le schéma d'un miroir de courant utilisable dans un amplificateur réalisé avec des transistors à effet de champ.

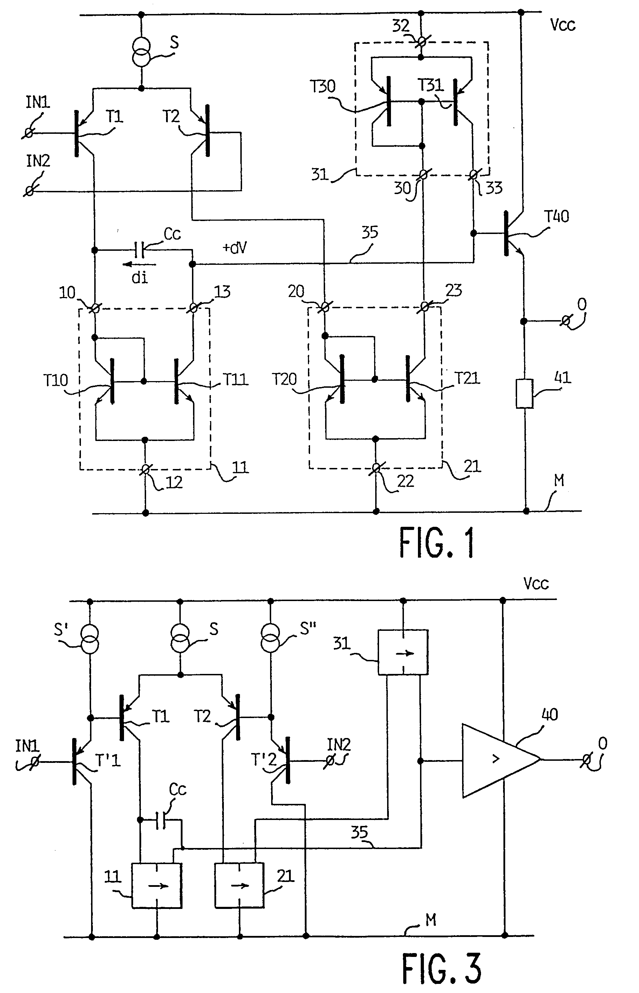

Le schéma de l'amplificateur représenté à la figure 1 comporte : un étage différentiel d'entrée composé d'une source de courant S et une paire de transistors pnp T1 et T2 dont les émetteurs sont directement couplés à la source de courant S et dont les bases reçoivent les signaux d'entrée IN1 et IN2. Le courant collecteur du transistor T1 est appliqué à la borne de commande 10 d'un premier miroir de courant 11 formé du transistor npn T10 connecté en diode, lequel à ses électrodes de base et d'émetteur respectivement connectés aux électrodes de base et d'émetteur d'un transistor T11 dont le collecteur constitue la branche de sortie de ce miroir connecté à la borne 13. La liaison commune des émetteurs des transistors T10 et T11 est reliée à la ligne d'alimentation négative via la borne 12 du miroir. D'une manière similaire, le courant collecteur du transistor T2 de la paire différentielle d'entrées est appliqué à la borne de commande 20 d'un deuxième miroir de courant 21 formé des transistors npn T20 et T21, le transistor T20 étant connecté en diode.

La base et l'émetteur de ce transistor sont accouplés respectivement à la base et à l'émetteur du transistor T21, ce dernier formant par son collecteur la branche de sortie du deuxième miroir de courant 21, reliée à la borne 23. Les émetteurs du transistor T20 et T21 sont reliés à la ligne d'alimentation négative via la borne 22 du miroir de courant 21.

Le courant de sortie du deuxième miroir de courant 21 est appliqué à la borne de commande 30 d'un troisième miroir de courant 31 formé des transistors pnp T30 et T31 le transistor T30 étant connecté en diode. Sa base et son émetteur reliés respectivement à la base et à l'émetteur du transistor T31.

La connexion réunissant les émetteurs des transistors T30 et T31 est reliée à la ligne d'alimentation positive Vcc via la borne 32 du troisième miroir de courant. Le collecteur du transistor T31 constitue la branche de sortie du troisième miroir de courant 31, appliquée à la borne 33. Celle-ci est reliée à la borne de sortie 13 du premier miroir de courant 11, et forme une liaison 35, dite noeud de sortie de l'étage différentiel d'entrée.

Un transistor de sortie T40 de type npn a son collecteur relié à la ligne d'alimentation positive Vcc et son émetteur relie à la ligne d'alimentation négative M, via une résistance de charge d'émetteur 41.

Sur l'émetteur du transistor T40 est présent le signal de sortie 0. La base du transistor T40 est alimentée par le noeud de sortie 35 de l'étage différentiel d'entrée. Ce noeud 35 est par ailleurs couplé par une capacité de stabilisation Cc à la branche de commande du premier miroir de courant 11 c'est-à-dire à la liaison entrante dans la borne de commande 10 de ce miroir.

L'effet de la capacité de stabilisation Cc va être maintenant évalué approximativement.

On appelera dV une variation de tension de sortie de l'étage différentiel d'entrée tel qu'il se présente sur la base du transistor T40 dans un intervalle de temps dt, et C la valeur de la capacité de stabilisation Cc. On considère que la variation de tension de la borne de commande 10 du premier miroir de courant 11 est si faible qu'elle peut être négligée, puisqu'elle correspond à la tension émetteur/base du transistor T10 qui varie selon une fonction logarithmique par rapport au courant émetteur.

Le courant di traversant la capacité de stabilisation Cc est ainsi donné par :

$$di = C\, dV/dt$$

La variation de courant di est d'une part déviée vers la masse M via la diode base-collecteur du transistor T10 et d'autre part recopiée par le transistor T11 pour fournir une absorption de courant di sur la borne de sortie 13 du premier miroir de courant 11. De la sorte, il se produit une variation de -2.di sur le noeud de sortie 35 de l'étage différentiel d'entrée. L'effet de la capacité de stabilisation Cc est donc doublé par rapport à la valeur physique C de la capacité utilisée.

L'évaluation précédente suppose que le premier miroir de courant 11 à un rapport de courant de sortie sur courant de commande qui est égal à 1 ou très voisin de 1 ainsi que cela est représenté sur la figure, les transistors T10 et T11 étant supposés appairés du point de vue de leur surface de jonction émetteur/base.

Il est avantageux toutefois d'utiliser un rapport de courant de sortie sur courant de commande plus grand que 1 et égal à N. En effet dans ce cas la variation di de courant traversant le transistor T10 est recopiée par le transistor T11 avec un coefficient de multiplication N de sorte que l'absorption de courant dû à la capacité de stabilisation Cc sur le noeud de sortie 35 de l'étage différentiel d'entrée devient maintenant égal à : di·(1 + N).

L'effet de la capacité de stabilisation par rapport à sa valeur physique se trouve maintenant multiplié par le facteur 1 + N. Ainsi, cette capacité devient facile à intégrer du fait de son faible encombrement.

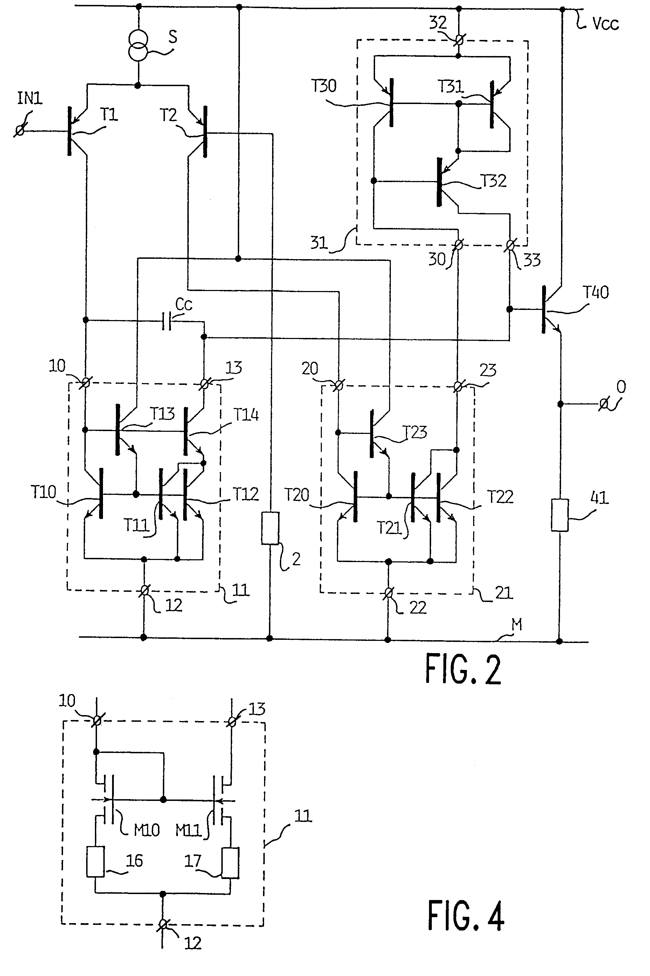

La figure 2 représente le schéma d'un amplificateur selon l'invention dans lequel les premier et deuxième miroirs de courant ont un rapport de courant de sortie sur courant de commande plus grand que 1. Sur cette figure les éléments correspondants à ceux de la figure 1 sont affectés des mêmes signes de référence.

Par rapport à la figure 1, la paire de transistors d'entrée T1, T2 se présente de manière similaire, à ceci près que la base du transistor T2 est couplée à la masse M via une résistance de base 2.

Sur cet étage un seul signal d'entrée IN1 est appliqué à la base du transistor T1. Les premier et deuxième miroirs de courant 11, 21 sont réalisés pour fournir un courant de sortie N fois plus élevé que leur courant de commande appliqué aux bornes respectives 10 et 20 ce qui est représenté symboliquement par plusieurs transistors T11, T12 respectivement T21, T22 fournissant les courants de sortie.

Bien entendu cette représentation est symbolique et n'implique pas nécessairement que leur rapport de courant de sortie sur courant de commande soit égal à 2, mais il peut être choisi avec un facteur N prenant toute valeur désirée plus grande que 1.

Dans le premier miroir de courant 11, le courant de base des transistors T10, T11, T12 est fourni par un transistor additionnel T13 dont la base est alimentée à partir de la borne de commande 10 de ce miroir, dont le collecteur est relié à la ligne d'alimentation positive Vcc, tandis qu'un autre transistor additionnel T14 a sa base couplée à la base du transistor T13, son émetteur qui reçoit la somme des courants collecteur T11 et T13 et son collecteur, relié à la borne de sortie 13 du miroir.

Dans le deuxième miroir de courant 21 le courant de base des transistors T20, T21, T22 est fourni par un transistor additionnel T23 dont la base est reliée à la borne de commande 20 de ce miroir et dont le collecteur est relié à la ligne d'alimentation positive Vcc.

Si la tension de collecteur du transistor T14 varie dans de grandes proportions puisqu'elle correspond à la tension de sortie de l'étage différentiel d'entrée, la tension à la borne de sortie 23 du deuxième miroir de courant 21 est sensiblement constante. En conséquence, les collecteurs des transistors T21 et T22 ont été reliés directement à la borne de sortie 23 sans interposition d'un transistor supplémentaire comme cela à été réalisé dans le premier miroir de courant (transistor T14).

Le troisième miroir de courant 31 est construit pour réaliser un rapport de courant de sortie sur courant de commande très voisin de 1. Par rapport à la figure 1 il comporte un transistor supplémentaire T32 dont l'émetteur alimente les courants de base des transistors T30 et T31 ainsi que le courant collecteur de ce même transistor T31. Le transistor T32 a sa base reliée au collecteur du transistor T30 et son collecteur relié à la borne de sortie 33 de ce troisième miroir de courant. En définitive l'amplificateur de la figure 2 se déduit de celui de la figure 1 mais en utilisant des premier et deuxième miroirs de courant fournissant un rapport de courant de sortie sur courant de commande plus grand que 1, et tous les miroirs de courant étant d'un type un peu plus perfectionné.

On se reporte maintenant à la figure 3 qui représente de manière très schématisée un amplificateur correspondant à une autre variante de l'invention.

L'étage différentiel d'entrée comporte ici encore une paire de transistors pnp T1 et T2 dans le trajet collecteur desquels sont insérés repectivement les premier et deuxième miroirs de courant 11 et 21.

Toutefois les signaux d'entrée IN1 et IN2 sont appliqués sur les bases d'une deuxième paire de transistors d'entrée T'1 et T'2 dont les émetteurs sont connectés respectivement aux bases des transistors T1 et T2 ainsi qu'à des sources de courant annexes S' et S'' et dont les collecteurs sont reliés à la ligne d'alimentation négative M. Comme dans les précédents exemples, la sortie du deuxième miroir de courant 21 est reliée à l'entrée d'un troisième miroir de courant 31 pour réaliser une différence de courant de sortie de l'étage d'entrée sur le noeud 35 en sortie de cet étage, lequel est connecté à l'entrée d'un amplificateur 40 fournissant le signal de sortie 0.

Dans les exemples précédents l'étage de sortie se réduisait simplement à un transistor T40 à charge d'émetteur.

Comme schématisé ici, l'invention s'applique à tout autre type d'étage de sortie d'amplification de puissance dès lors que cet étage 40 est stable en fréquence et possède donc un gain en tension modéré.

On à vu précédemment que le premier miroir de courant 11 était prévu avantageusement avec un rapport de courant de sortie à son courant de commande égal à N, supérieur à 1, de manière à amplifier l'effet de capacité de stabilisation Cc. Pour des raisons de symétrie d'utilisation des composants, il est souvent préférable de réaliser le deuxième miroir de courant 21 fournissant le même rapport N de courant de sortie par rapport à son courant de commande et, dès lors, de construire le troisième miroir de courant 31 avec un rapport courant de sortie sur courant de commande égal à 1.

Toutefois, l'invention s'applique encore lorsque le deuxième miroir de courant 21 à un rapport unitaire tandis que c'est le troisième miroir de courant 31 qui présente un rapport courant de sortie sur courant de commande plus grand que 1, et égal à N, identique au rapport prévu pour le premier miroir de courant 11.

Enfin, si dans ces exemples les transistors utilisés pour réaliser l'amplificateur selon l'invention sont des transistors du type bipolaire, il est encore possible d'utiliser des transistors à effet de champ selon une configuration semblable, les grilles, sources et drains de ces transistors à effet de champ étant connectés en lieu et place respectivement des bases émetteurs et collecteurs des transistors bipolaires précédemment utilisés.

Pour réaliser l'un des miroir de courant tel que le premier miroir de courant 11, comme indiqué à la figure 4, il peut être avantageux d'équilibrer le partage des courants de commande et de sortie de ces miroirs non seulement par une différence de géométrie des transistors utilisés mais aussi en insérant des résistances telles que les résistances 16 et 17 entre les sources des transistors M10, M11 et la borne 12 reliée elle-même à la ligne d'alimentation négative M. On améliore de cette manière la précision du rapport N de courant de sortie sur courant de commande quand on utilise des transistors à effet de champ.

Il est clair que le deuxième miroir de courant 21 peut être construit d'une manière tout à fait analogue au premier miroir de courant représenté à la figure 4, tandis que le troisième miroir de courant 31 peut être réalisé de manière semblable en utilisant des transistors à type de canal opposé, dont les sources seront couplées à la ligne d'alimentation positive Vcc.

D'autres modifications de détail pourront être aisément prévues par le spécialiste sans pour autant sortir du cadre de la présente invention, revendiquée ci-après.

**Revendications**

1. Amplificateur comprenant :
   - un étage différentiel d'entrée comportant au moins une paire de transistors d'entrée, dont les électrodes de référence sont couplées entre elles, dont les électrodes de commande sont couplées à un signal d'entrée,
   - une capacité dite de stabilisation, disposée de manière à produire une atténuation du signal de sortie pour une fréquence élevée du signal d'entrée,
   - et un miroir de courant dont une branche de commande est insérée dans le trajet de courant de sortie de l'un au moins des transistors de ladite paire d'entrée, caractérisé en ce que le dit miroir de courant étant appelé premier miroir, un deuxième miroir de courant est inséré par sa branche de commande, dans le trajet de courant de sortie de l'autre transistor de la paire d'entrée, en ce que le courant de sortie de ce deuxième miroir est appliqué à une branche de commande d'un troisième miroir de courant, de polarité inverse de celle des dits premier et deuxième miroirs de courant, en ce que les branches de sortie des premier et troisième miroirs de courant sont reliées pour former un noeud de sortie de l'étage différentiel d'entrée,

et en ce que ce noeud est couplé à la branche de commande du premier miroir de courant via la capacité de stabilisation.

2. Amplificateur selon la revendication 1, caractérisé en ce que le troisième miroir de courant étant prévu avec un rapport du courant de sortie au courant de commande pratiquement égal à 1, le rapport du courant de sortie au courant de commande du premier et du deuxième miroir de courant, est choisi égal à N, plus grand que 1.

3. Amplificateur selon la revendication 1, caractérisé en ce que le deuxième miroir de courant étant prévu avec un rapport du courant de sortie au courant de commande pratiquement égal à 1, le rapport du courant de sortie au courant de commande du premier et du troisième miroir de courant, est choisi égal à N, plus grand que 1.

FIG. 1

FIG. 3

FIG. 2

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | IBM TECHNICAL DISCLOSURE BULLETIN., vol.28, no.9, Février 1986, NEW YORK US page 3812 'IMPROVED OPERATIONAL AMPLIFIER DESIGN FOR ANALOG LSI APPLICATIONS' * le document en entier * | 1,3 | H03F1/08 H03F3/45 |
| Y A | US-A-4 590 435 (T. TANAKA) * colonne 4, ligne 56 - colonne 7, ligne 3; figures 6-9 * | 1,3 2 | |
| A | US-A-4 620 161 (T. TANAKA ET AL) * colonne 6, ligne 32 - colonne 9, ligne 32; figures 8-11 * | 1,2 | |
| A | GB-A-2 019 148 (AMERICAN OPTICAL CORPORATION) * page 2, ligne 42 - ligne 116; figure 4 * | 1 | |

DOMAINES TECHNIQUES
RECHERCHES (Int.Cl.5)

H03F

Le présent rapport a été établi pour toutes les revendications

| Lieu de la recherche | Date d'achèvement de la recherche | Examinateur |
|---|---|---|
| LA HAYE | 4 Mai 1994 | Tyberghien, G |

EPO FORM 1503 03.82 (P04C02)